Europäisches Patentamt

European Patent Office

Office européen des brevets

(11) Veröffentlichungsnummer: **0 334 022**
**A1**

# EUROPÄISCHE PATENTANMELDUNG

(21) Anmeldenummer: 89102848.2

(51) Int. Cl.⁴: **H05K 13/00**

(22) Anmeldetag: 18.02.89

(30) Priorität: 23.03.88 CH 1099/88

(43) Veröffentlichungstag der Anmeldung:
27.09.89 Patentblatt 89/39

(84) Benannte Vertragsstaaten:
AT BE CH DE ES FR GB IT LI NL SE

(71) Anmelder: SIEMENS-ALBIS
AKTIENGESELLSCHAFT
PVP/Verträge und Patente Postfach
CH-8047 Zürich(CH)

(84) CH LI

Anmelder: Siemens Aktiengesellschaft
Wittelsbacherplatz 2
D-8000 München 2(DE)

(84) BE DE ES FR GB IT NL SE AT

(72) Erfinder: Bachofner, Bruno
Oberdorfstrasse 16
CH-8906 Bonstetten(CH)
Erfinder: Grob, Peter
Rebenstrasse 8
CH-8307 Effretikon(CH)
Erfinder: Bajka, Imre
Geeringstrasse 35
CH-8049 Zürich(CH)

(54) Verfahren und Vorrichtung zum Aufbringen eines Ueberzuges auf Gegenstände.

(57) Die Vorrichtung weist eine Ladekammer (3) und eine Tauchkammer (4) auf, welchen unabhängig voneinander ein Gas - z.B. Stickstoff - zuführbar ist, um darin eine Atmosphäre bestimmter Feuchtigkeit zu erzeugen. In der Tauchkammer (4) befindet sich eine zur Umhüllung geeignete, unter Einfluss von Luftfeuchtigkeit aushärtende flüssige Masse, deren Homogenität durch ein Rührwerk (8, 9, 10, 11, 23) auf einem erforderlichen Wert gehalten wird. Den zu umhüllenden Gegenständen (13) wird in der Ladekammer (3) zunächst die Feuchtigkeit von ihrer Oberfläche entzogen. Anschliessend werden sie in der Tauchkammer (4) in die Masse getaucht. Die Gaszuführung in der Tauchkammer (4) erfolgt derart, dass ein Eindringen von Feuchtigkeit in die aufgerührte Masse verhindert ist. Die Regelung des Gashaushalts in den beiden Kammern (3, 4), die Steuerung des Rührwerkes (8, 9, 10, 11) und das Ein- und Austauchen der Gegenstände (13) erfolgen durch eine programmierbare Steuereinrichtung. Nach dem Austauchen werden die Gegenstände (13) erhöhter Feuchtigkeit ausgesetzt. Die Vorrichtung gewährleistet eine auch bei grossen Stückzahlen gleichbleibende Qualität der Umhüllung.

Fig 1

## Verfahren und Vorrichtung zum Aufbringen eines Überzuges auf Gegenstände

Die vorliegende Erfindung betrifft ein Verfahren gemäss dem Oberbegriff des Patentanspruches 1 sowie eine Vorrichtung zu dessen Durchführung und eine Anwendung.

Elektronische Bauteile und Schaltungen, wie beispielsweise Hybridschaltungen, werden zum Schutz vor Feuchtigkeit, Staub, unerwünschter Berührung und mechanischen Beschädigungen durch Eintauchen in lackartige, unter Einfluss von Feuchtigkeit und/oder Wärme aushärtende Massen umhüllt. Als Mittel zur Imprägnierung eignen sich insbesondere Silikonkautschuke (m-Polymere), die im Verarbeitungszustand flüssig sind und unter Einfluss von Feuchtigkeit aushärten, wobei dann eine gewisse Elastizität erhalten bleibt. Um die zur optimalen Verarbeitung erforderliche Homogenität zu erreichen, ist es in der Regel notwendig, die Tauchmasse regelmässig durchzumischen bzw. umzurühren.

Der vorliegenden Erfindung liegt die Aufgabe zugrunde, ein Verfahren der eingangs genannten Art anzugeben, welches unter Berücksichtigung der besonderen Eigenschaften von in Frage kommenden Überzugslacken ein Umhüllen von Gegenständen, wie z.B. auf einem Träger angeordnete Schaltungen, in einem möglichst automatisierten Ablauf ermöglicht und einen höchsten Ansprüchen genügenden Überzug gewährleistet. Diese Aufgabe wird erfindungsgemäss mit den im Kennzeichen des Patentanspruches 1 angegebenen Massnahmen gelöst. Eine Vorrichtung zur Durchführung des Verfahrens sowie vorteilhafte Weiterbildungen der Erfindung sind in weiteren Ansprüchen angegeben.

Die Erfindung eignet sich für den Einsatz in einer weitgehend automatischen Fertigungsstrasse und ermöglicht eine auch für Grosserien gleichbleibende einwandfreie Überzugsqualität. Dadurch, dass den Gegenständen vor dem Eintauchen die Feuchtigkeit an ihrer Oberfläche entzogen wird, wird die Haftung der Überzugsmasse verbessert, ohne dass ein Haftmittel eingesetzt werden muss.

Nachfolgend werden das Verfahren und eine Vorrichtung zu dessen Durchführung anhand von Zeichnungen beispielsweise näher erläutert. Es zeigt:

Fig.1 den prinzipiellen Aufbau der Vorrichtung

Fig.2 Einzelheiten zur Gasversorgung in den beiden Kammern der Vorrichtung

Fig.3 weitere Einzelheiten in einer Seitenansicht der Vorrichtung

Fig.4 eine Aushärtungsstation

Fig.5 und 6 Einzelheiten der Aushärtungsstation

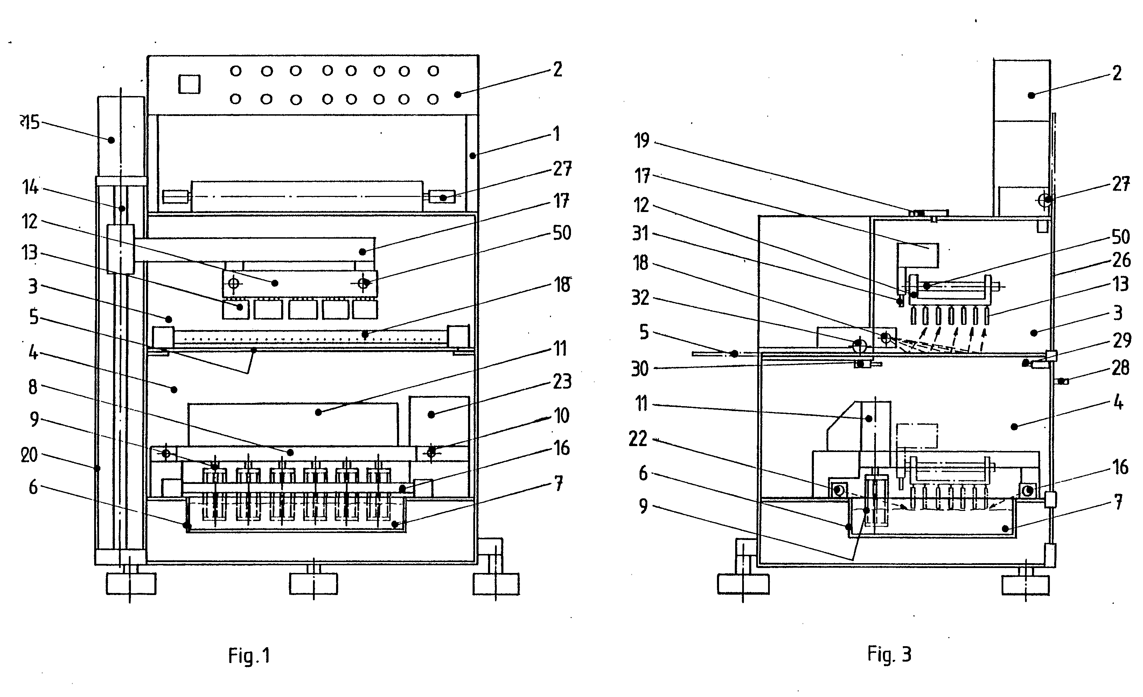

Fig. 1 zeigt die zum Verständnis der Erfindung wesentlichen Teile der Vorrichtung. Diese ist in einem Gehäuse 1 untergebracht und besteht aus einem Bedienungsteil 2, einer Ladekammer 3 und einer darunterliegenden Tauchkammer 4. Jede Kammer ist über eine separate Türe von vorne zugänglich. Die Tauchkammer 4 ist bei geschlossener Türe nahezu hermetisch von der Aussenwelt und von der Ladekammer 3 abgeschlossen. In der horizontalen Trennwand zwischen den beiden Kammern 3, 4 ist ein Schieber 5 angeordnet, der horizontal von vorn nach hinten und umgekehrt verschoben werden kann und im geöffneten Zustand einen Durchgang zwischen der Ladekammer 3 und der Tauchkammer 4 freigibt.

In der Tauchkammer 4 befindet sich eine Wanne 6 mit einem Gefäss 7, das eine flüssige Tauchmasse enthält, die zur Umhüllung der eingetauchten Gegenstände - nachfolgend kurz Tauchgut genannt - eingesetzt wird. Über der Wanne 6 ist ein Rührwerk angeordnet, das über die ganze Breite der Wanne 6 verteilt an einem Träger 8 angeordnete und in die Tauchmasse hineinragende Rührer 9 aufweist. Der Träger 8 ist beidseitig oberhalb des Randes der Wanne 6 verschiebbar abgestützt und von vorn nach hinten und umgekehrt verschiebbar, wobei der Antrieb durch einen Motor 23 über eine Spindel 10 erfolgt. Die Rührer 9 werden miteinander über ein Zahnradsystem durch einen weiteren Motor 11 in Drehung versetzt, wobei benachbarte Rührer 9 sich gegensinnig drehen. Die Rührer 9 sind aus ihrer vertikalen Lage in eine wenigstens annähernd horizontale Lage so schwenkbar, dass zum Auswechseln der Tauchmasse bei geöffneter Tür das Gefäss 7 ohne weiteres der Wanne 6 entnommen werden kann. Weitere Einzelheiten zum Aufbau eines hier in vorteilhafter Weise einsetzbaren Rührwerkes sind in der CH-PS 662751 ausführlich beschrieben, weshalb nicht weiter darauf eingegangen wird.

Die Vorrichtung weist ferner einen Halter 12 zur Aufnahme des Tauchgutes auf. Dieser Halter 12 befindet sich in der Ruhelage der Vorrichtung - wie in Fig. 1 gezeigt - in der Ladekammer 3. Er ist entsprechend dem aufzunehmenden Tauchgut 13 ausgebildet. Im vorliegenden Fall, wo z.B. Hybrid-Schaltungen zu umhüllen sind, kann der Halter 12 mit einer Klemmeinrichtung versehen sein, die die Anschlusskämme der in einer oder mehreren Reihen angeordneten Schaltungen aufnimmt und während des Tauchvorganges festhält. Der Halter 12 ist entfernbar an einem Arm 17 angebracht, der mit einer vertikal angeordneten Spindel 14 gekoppelt ist, die von einem Schrittmotor 15 angetrieben wird. Der Halter 12 ist somit in vertikaler Richtung von der Ladekammer 3 in die Tauchkammer 4 und umgekehrt verschiebbar und gleitet dabei in einem vertikalen Schlitz in der Wand des Gehäuses 1. Um dies zu verdeutlichen, ist die an sich in einem Gehäuse 20 untergebrachte Spindel 14 in Fig. 1 sichtbar dargestellt. Der Schrittmotor 15 erlaubt eine genaue Positionierung des Halters 12 innerhalb seines Verschiebeweges. So kann eine vorgegebene Eintauchtiefe des Tauchgutes genau eingehalten werden. Dies ist besonders wichtig, da die Eintauchtiefe für unterschiedliche Tauchgüter verschieden sein kann. Des weiteren ermöglicht der Schrittmotor 15 den für eine gleichbleibende Eintauchtiefe erforderlichen Verschiebeweg des Halters 12 jeweils dem durch den fortlaufenden Verbrauch der Tauchmasse sinkenden Niveau im Gefäss 7 in noch näher beschriebener Weise genau anzupassen.

Unmittelbar über der Oberfläche der flüssigen Tauchmasse im Gefäss 7 sind Elemente zum Zuführen eines die Luftfeuchtigkeit in der Tauchkammer 4 auf einen bestimmten maximalen Wert reduzierenden Gases - z.B. Stickstoff - oder von getrockneter Luft, die einen bestimmten Feuchtigkeitswert nicht überschreitet, vorgesehen. In Fig. 1 ist ein Gaszuführungselement 16 auf der vorderen Umrandung der Wanne 6 gezeigt, welches mehrere nach innen gerichtete und daher nicht sichtbare düsenartige Öffnungen über die ganze Breite der Wanne 6 verteilt aufweist. Es ist denkbar, solche Gaszuführungselemente 16 auf einer oder auf mehreren Seiten der Wanne 6 vorzusehen. Auch in der Ladekammer 3 ist mindestens ein Gaszuführungselement 18 mit düsenartigen Öffnungen zum Zuführen von getrockneter Luft bzw. eines die Luftfeuchtigkeit reduzierenden Gases, beispielsweise an der Rückwand, vorhanden. Die Ladekammer 3 ist relativ klein, um mit einer möglichst geringen Gasmenge die gewünschte Verringerung der Luftfeuchtigkeit zu erreichen.

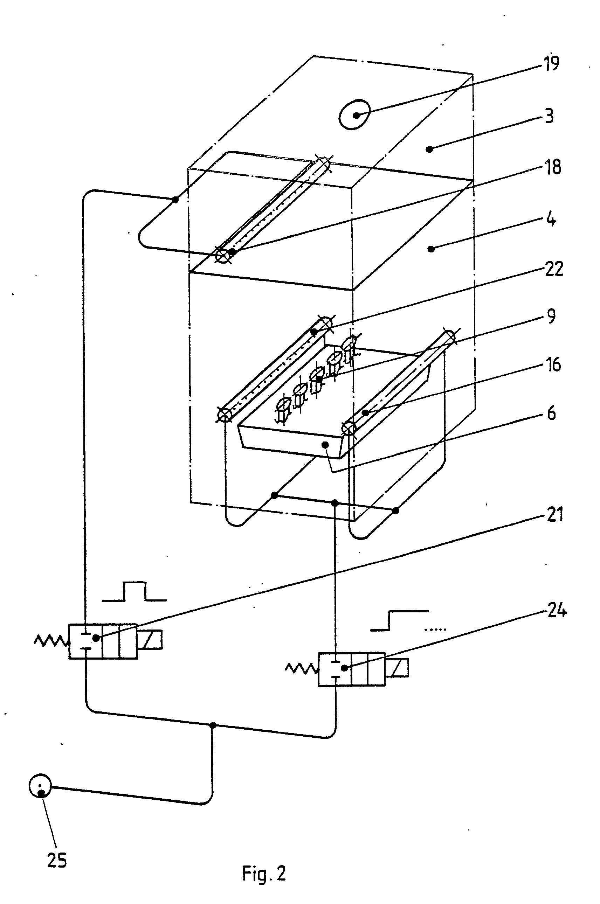

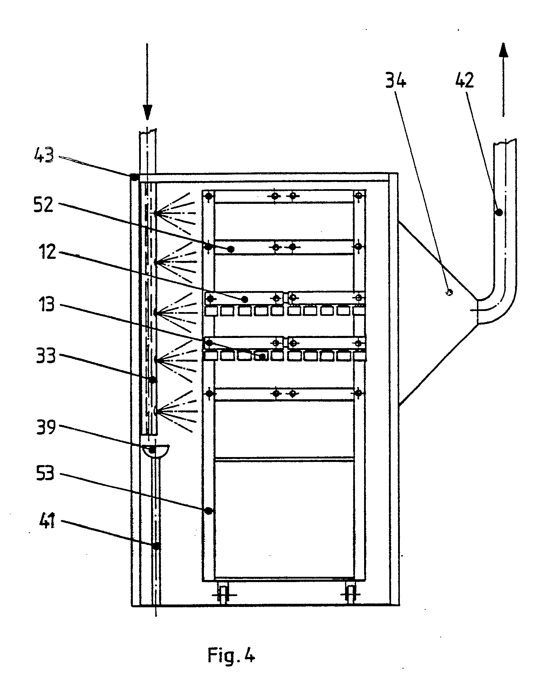

Einzelheiten zur Gasversorgung in der Vorrichtung zeigen Fig.2 und 3, in der gleiche Teile mit den gleichen Hinweiszeichen versehen sind wie in Fig. 1. In der Ladekammer 3, welche oben eine auf einen bestimmten Druck ansprechende klappenartige Gasaustrittsöffnung 19 (Fig. 3) aufweist, sind mehrere Düsen in Form eines horizontal über der Trennwand angeordneten perforierten Rohres 18 vorgesehen, und zwar derart gerichtet, dass das Gas in Richtung der Trennwand der beiden Kammern 3, 4 bzw. des Schiebers 5 ausströmt, dort "reflektiert" wird und dann nach oben in Richtung der Austrittsöffnung 19 strömt. Das Rohr 18 ist über eine Leitung, welche ein steuerbares Ventil 21 mit einstellbarem Gasdurchfluss enthält, mit einer z.B. Stickstoff oder getrocknete Luft liefernden Quelle 25 verbunden. In der Tauchkammer 4 ist über oder auf zwei parallel zu den Rührern 9 verlaufenden Rändern des Behälters 6 je ein perforiertes Rohr 16, 22 angeordnet, die über Zuleitungen an eine gemeinsame, ebenfalls ein steuerbares Ventil 24 mit einstellbarem Gasdurchfluss enthaltende und mit der Quelle 25 verbundene Zubringerleitung angeschlossen sind. Die Löcher der Rohre 16, 22 sind so gegen das Gefäss 7 gerichtet, dass das ausströmende Gas direkt auf die Oberfläche der Tauchmasse strömt, dort "reflektiert" wird und dann nach oben strömt. Über der Tauchmasse entsteht somit ein "Schutzvorhang", der ein Eindringen von Feuchtigkeit in die aufgerührte Tauchmasse weitgehend verhindert. Die käfigförmige Ausgestaltung der Rührer 9 des Rührwerkes gemäss CH-PS 662751 gewährleistet in jedem Fall die Aufrechterhaltung des Schutzvorhanges, da das Gas jederzeit praktisch ungehindert zwischen den Stäben der Rührer 9 hindurchströmen kann. Die Ladekammer 3 ist bei geschlossenem Schieber 5 nicht absolut hermetisch von der Tauchkammer 4 abgeschlossen. Durch Aufrechterhaltung eines Gasüberdruckes in der Tauchkammer 4 kann daher allenfalls in der Tauchkammer 4 noch vorhandene Feuchtigkeit in die Ladekammer 3 und durch deren Austrittsöffnung 19 nach aussen entweichen. Der Verlauf der Gasströmung in den beiden Kammern 3, 4 ist in Fig.3 durch gestrichelte Pfeile angedeutet.

Die Antriebsmittel für das Rührwerk, die Spindel 14, den Schieber 5, die Türe 26 (Fig. 3) zur Ladekammer 3 sowie die Gaszuführung über die Ventile 21, 24 werden über eine speicherprogrammierbare Steuereinrichtung - die sich im Bedienungsteil 2 befindet - gesteuert, wobei der Bedienteil die zur Bedienung und zur Auswahl des gewünschten Tauchprogramms notwendigen Bedienelemente enthält. Die frontseitige Türe 26 zur Ladekammer 3 ist über eine Zahnschiene, in die ein angetriebenes Zahnrad 27 eingreift, vertikal verschiebbar. Nach dem gleichen Prinzip ist der Schieber 5 über ein durch einen nicht dargestellten Motor angetriebenes Zahnrad 32 horizontal verschiebbar.Die Steuereinrichtung - beispielsweise eine bekannte SIMATIC-Steuerung - ist so programmiert, dass nebst einem selbsttätigen Ablauf eines vollständigen Tauchvorganges über den Bedienungsteil 2 auch einzelne Schritte, wie z.B. Vorschub des Halters 12 über einen gewünschten Weg, ausgelöst werden können, was vor allem bei Tauchversuchen für neue Typen von zu umhüllenden Gegenständen nützlich ist. Dabei können die für ein optimales Umhüllen massgeblichen Parameter wie Eintauchtiefe, Rührgeschwindigkeit und Rührzyklen des Rührwerkes, Gaszufur, Tauchzeit und Wartezeiten vor und nach dem TAuchen sowie die Tauchgeschwindigkeit ermittelt und dann als spezifische Daten für ein bestimmtes Tauchgut in das betreffende Ablaufprogramm der Steuereinrichtung eingegeben werden.

In der eine Seitenansicht der Vorrichtung zeigenden Fig.3 ist der Halter 12 mit dem Tauchgut 13 in seiner Ausgangslage in der Ladekammer 3 und gestrichelt in der Tauchlage in der Tauchkammer 4 dargestellt. In der Tauchlage befinden sich die Rührer 9 am hinteren Rand des Gefässes 7, so dass sie das Eintauchen nicht behindern. Die Tür zur Tauchkammer 4 weist einen Griff 28 auf und ist nach vorn und nach unten schwenkbar gelagert. Am Halter 12 ist ein als Reflexionslichtleiter ausgebildeter vertikal nach unten gerichteter Detektor 31 angeordnet. Der Detektor 31 weist einen nach unten gerichteten Sende- und einen ebenfalls nach unten gerichteten Empfangslichtleiter auf. In der Tauchkammer 4 ist eine aus Sender 29 und Empfänger 30 bestehende horizontale Lichtschranke derart angeordnet, dass deren Strahlengang beim Durchgang des mit dem Tauchgut bestückten Halters 12 unterbrochen wird. Diese Lichtschranke und der Detektor 31 sind signalmässig mit der Steuereinrichtung verbunden.

Die Arbeitsweise der gezeigten Vorrichtung ist folgende: Der Halter 12 wird zunächst ausserhalb der Vorrichtung mit dem Tauchgut bestückt und dann bei geöffneter Türe 26 in der Ladekammer 3 auf Dorne 50 am Arm 17 aufgesetzt. Sobald das dem vorliegenden Tauchgut entsprechende Tauchprogramm gestartet wird und die zur Vorbereitung der Tauchmasse gewählte Rührzeit - ein Durchmischen der Tauchmasse ist erforderlichenfalls nach einzelnen Tauchvorgängen und/oder nach dem Auswechseln des Gefässes 7 vorzusehen - abgelaufen ist, schliesst die Tür 26 zur Ladekammer 3 und das Rührwerk nimmt eine das Eintauchen nicht behindernde Ruhelage ein. Anschliessend beginnt das Gas in die Ladekammer 3 einzuströmen. Das Tauchgut wird durch das von der horizontalen Trennwand mit dem noch geschlossenen Schieber 5 nach oben strömende Gas umflutet und dabei seiner Oberfläche die Feuchtigkeit weitgehend entzogen. Sobald die zum Reduzieren der Luftfeuchtigkeit in der Ladekammer 3 auf einen annähernd der Luftfeuchtigkeit in der Tauchkammer entsprechenden Wert notwendige Gaseinströmungszeit abgelaufen ist, wird der Schieber 5 geöffnet und das Tauchgut mit zunächst relativ grosser Geschwindigkeit nach unten bewegt. In der Tauchkammer 4 wird durch entsprechende Gaszuführung ständig eine Atmosphäre bestimmter Luftfeuchtigkeit (im vorliegenden Fall von zu verarbeitendem m-Polymerlack in der Grössenordnung < 10%) aufrechterhalten. Wenn die horizontale Lichtschranke 29, 30 durch das vorbeigleitende Tauchgut unterbrochen wird, wird die Abwärtsbewegung gestoppt. Aus dem Abstand der Ausgangslage des Halters 12 zur Lichtschranke und dem bis zum Erreichen der Lichtschranke zurückgelegten Weg errechnet die Steuereinrichtung die Höhe des Tauchgutes, d.h. dessen Abmessung in vertikaler Richtung, um dann daraus näherungsweise den bis zum Erreichen des Niveaus der Tauchmasse durch die Unterkante des Tauchgutes noch zurückzulegenden Weg zu ermitteln. Stellt die Steuereinrichtung auf diese Weise fest, dass der Halter 12 kein Tauchgut enthält, wird der Tauchvorgang abgebrochen. Trifft dies nicht zu, wird der Halter 12 mit etwas geringerer Geschwindigkeit erneut nach unten bewegt, bis das Tauchgut das Niveau der Tauchmasse nahezu erreicht. Nun wird das Tauchgut mit vorbestimmter Geschwindigkeit - die entsprechende optimale Geschwindigkeit kann vorgängig für ein bestimmtes Tauchgut ermittelt und dann als Parameter in das betreffende Programm eingegeben werden - eingetaucht. Die Eintauchtiefe wird dabei von dem am Halter 12 fix angebrachten Detektor 31 bestimmt, indem dieser nach Erreichen eines bestimmten Abstandes vom Niveau der Tauchmasse und damit nach Erreichen eines bestimmten Abstandes zwischen der Unterkante des Halters 12 und dem Niveau der Tauchmasse aktiviert wird und den Tauchvorgang stoppt. Da die Aktivierung des Detektors 31 somit vom Niveau der Tauchmasse abhängig ist, bleibt die Eintauchtiefe trotz dem durch den ständigen Verbrauch an Tauchmasse sinkenden Niveau im Gefäss 7 immer gleich. Die Eintauchtiefe kann durch entsprechende Wahl des Abstandes zwischen dem der Tauchmasse zugewandten Ende des Detektors 31 und der Unterkante des Halters 12 festgelegt werden. Da im besonderen Anwendungsfall von Schichtschaltungen die Anschlusskämme der verschiedenen Typen in der Regel gleichlang sind, genügt eine einmalige Einstellung dieses Abstandes. Um trotzdem noch erforderliche Korrekturen zu ermöglichen, kann im betreffenden Programm die Eingabe eines Parameters vorgesehen werden, der eine entsprechende Verlängerung des Tauchweges bewirkt.

Wie bereits angedeutet, ist es dank der Programmierbarkeit der Steuereinrichtung möglich, verschiedene Varianten des Tauchprogramms vorzusehen, die entsprechend den Anforderungen an den Überzug auf dem Tauchgut auszugestalten sind. So kann ein mehrmaliges Ein- und Austauchen mit gleicher oder mit verschiedenen Geschwindigkeiten vorgesehen werden. Es können auch unterschiedliche Wartezeiten nach Erreichen der erforderlichen Eintauchtiefe vorgesehen werden. Alle diese an sich frei wählbaren Parameter richten sich in erster Linie nach der Art des Tauchgutes und nach den Eigenschaften der verwendeten Tauchmasse.

Sobald die Tauchphase abgeschlossen ist, wird das Tauchgut mit einer vorgewählten Geschwindigkeit aus der Tauchmasse gehoben und nach einer evtl. Wartezeit von der Tauchkammer 4 wieder in die Ladekammer 3 verbracht. Auch auf dem Rückweg können verschiedene Verweilzeiten, insbesondere unmittelbar nach dem Austauchen, und verschiedene Geschwindigkeiten vorgesehen werden. Wenn der Halter 12 die Ladekammer 3 erreicht hat, wird der Schieber 5 geschlossen und die Türe 26 zur Ladekammer 3 geöffnet, worauf der Halter 12 entnommen und durch einen neuen ersetzt werden kann. Das Rührwerk wird erforderlichenfalls aktiviert, um die Tauchmasse für einen nächsten Tauchvorgang aufzubereiten.

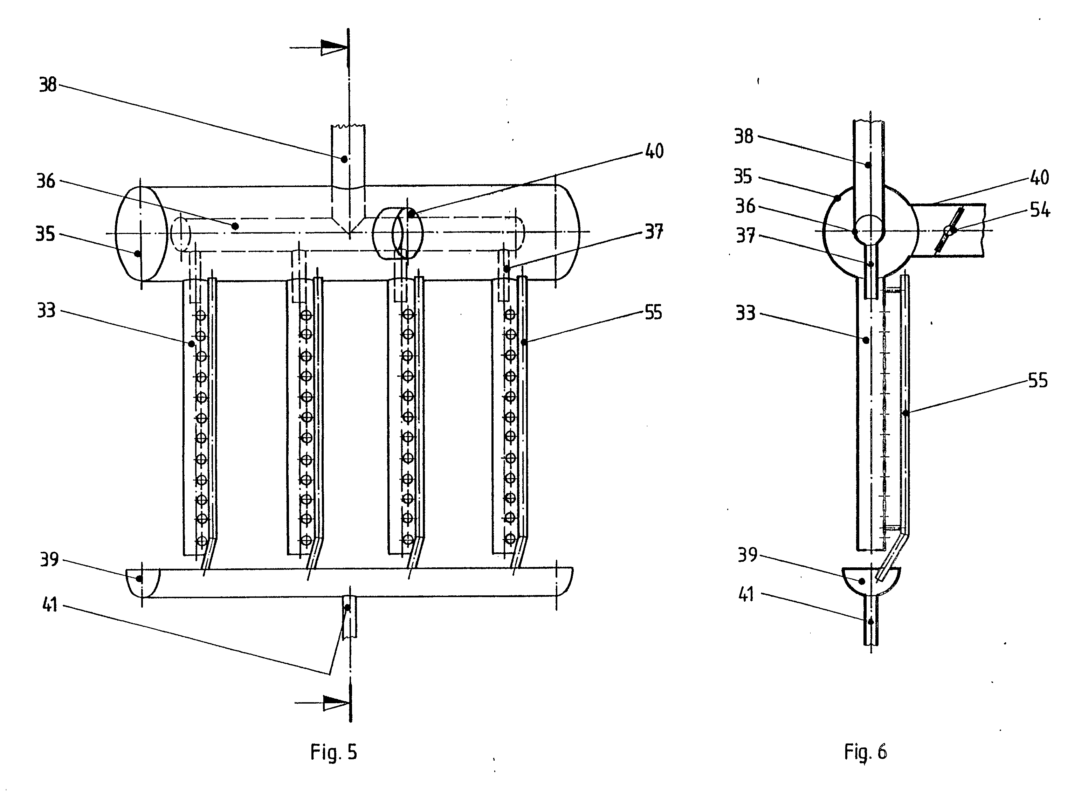

Das der Ladekammer 3 entnommene Tauchgut kann nun unter Einfluss der Umgebungsluft aushärten. Um jedoch eine für grosse Stückzahlen gleichbleibende gleichmässige Aushärtung zu erreichen sowie den Aushärtungsvorgang zu beschleunigen und damit die Durchlaufzeit in einer Fertigungsstrasse zu verkürzen, wird das Tauchgut in eine Aushärtungsstation verbracht. Einzelheiten hiezu zeigen Fig. 4, 5 und 6. Die Station besteht aus einem geschlossenen Gehäuse 43, das über eine Fronttüre zugänglich ist. Im vorliegenden Fall von umhüllten elektrischen Schaltungen werden mehrere die Schaltungen reihenweise tragende Halter 12 auf Dorne an einem Trägergestell 52 aufgesetzt, das auf einem fahrbaren Untergestell 53 angeordnet ist, welches in die Station eingeschoben wird. An einer quer zu den Reihen verlaufenden Seitenwand des Gehäuses 43 sind im Innern Elemente 33 zum Zuführen von feuchter Luft angebracht, und zwar derart, dass die feuchte Luft annähernd horizontal in Richtung des Trägers 52 ausströmt und dabei die in parallelen Reihen an den Haltern 12 hängenden umhüllten Schaltungen allseitig umflutet. An der gegenüberliegenden Wand befindet sich eine trichterförmige Sammelöffnung 34, welche über ein Rohr 42 mit einer Absaugeinrichtung für die in die Sammelöffnung 34 gelangende feuchte Luft verbunden ist. Einzelheiten zur Luftversorgung in der Aushärtungsstation über die Elemente 33 zeigen Fig. 5 und 6. Die Zuführung der feuchten Luft erfolgt über senkrecht nebeneinander angeordnete Elemente 33, welche als perforierte Rohre mit in das Innere der Station gerichteten Löchern ausgebildet sein können. Die Länge der Rohre entspricht in etwa der Höhe des Trägers 52. Die Elemente 33 sind mit einem beidseitig abgeschlossenen Verteilrohr 35 verbunden, das über einen Stutzen 40 an eine Druckluftquelle anschliessbar ist. Mit einer verstellbaren Klappe 54 kann die Luftzufuhr im Stutzen 40 wahlweise eingestellt werden. Im Innern des Verteilrohres 35 befindet sich ein weiteres beidseitig abgeschlossenes Verteilrohr 36 mit Stutzen 37, die von oben in die Elemente 33 hineinragen. Das Verteilrohr 36 ist mit einem weiteren Stutzen 38 versehen, der mit einer Wasserdampfquelle verbindbar ist. Die Steuerung der Zufuhr des Wasserdampfes aus der Dampfquelle erfolgt über einen in der Station angeordneten nicht gezeichneten Sensor, der ständig die Luftfeuchtigkeit im Innern misst. Unter dem freien, mindestens eine Perforation aufweisenden Ende der Elemente 33 ist eine Sammelrinne 39 angeordnet, in der sich bildendes Kondenswasser aufgefangen und über einen Ablauf 41 abgeführt wird. Um zu verhindern dass allenfalls auch aus den anderen Löchern der Elemente 33 austretendes Kondenswasser zum auszuhärtenden Tauchgut gelangen kann, kann parallel zu jedem Element 33 in einem Abstand zu den Löchern ein vorzugsweise zylindrischer Trennstab 55 vorgesehen werden, dessen unteres Ende in die Sammelrinne 39 hineinragt. Das Kondenswasser wird an diesem Stab aufgefangen und gleitet dabei nach unten in die Sammelrinne. Überdies sorgt der Trennstab 55 für eine bessere Verteilung des Wasserdampfes in der Aushärtungsstation, indem er den aus den Löchern austretenden Dampfstrahl aufteilt. Die Anordnung gemäss Fig. 5 und 6 stellt einen einfachen Mischer zur Erzeugung von Luft mit einstellbarer bestimmter Feuchtigkeit dar.

Die Absaugvorrichtung wird vorteilhafterweise so eingestellt, dass in der Station ein ständiger Unterdruck herrscht. Die seitlich über die ganze Höhe des Trägers 52 verteilt einströmende, mit Wasserdampf angereicherte Luft fliesst so annähernd horizontal zwischen den Reihen des Tauchgutes 13 hindurch. Es stellt sich somit ein gerichteter homogener Strom feuchter Luft ein, der ein beschleunigtes gleichmässiges Aushärten der Umhüllung des Tauchgutes gewährleistet, wobei die Qualität der Umhüllung auch bei grossen Stückzahlen gleich gut bleibt.

Zur Anwendung des beschriebenen Verfahrensprinzips ist es nicht zwingend, die Ladekammer 3 über der Tauchkammer 4 anzuordnen; die beiden Kammern könnten auch nebeneinander angeordnet werden. Das Verfahren eignet sich nicht nur wie im Einzelnen beschrieben zum Umhüllen von elektrischen Hybridschaltungen mit einem unter Einfluss von Feuchtigkeit auszuhärtenden Silikonkautschuk. Es kann auch zum Umhüllen irgendwelcher Gegenstände eingesetzt werden, wobei auch die Verwendung von Umhüllungsmassen denkbar ist, die statt durch Einfluss von Feuchtigkeit durch Zuführung von Wärme aushärten, wobei dann erforderlichenfalls als Aushärtungsstation eine an sich bekannte Wärmekammer vorgesehen werden könnte.

**Ansprüche**

1. Verfahren zum Aufbringen eines Überzuges auf Gegenstände, durch Eintauchen in eine unter Einfluss von Feuchtigkeit oder Wärme aushärtende flüssige Masse, gekennzeichnet durch folgende Schritte:

a) den Gegenständen wird vor dem Eintauchen durch Umflutung mit einem die Feuchtigkeit entziehenden Gas die Feuchtigkeit von ihrer Oberfläche entzogen

b) die Gegenstände werden anschliessend in die an ihrer Oberfläche durch einen Gasvorhang gegen Eindringen von Feuchtigkeit geschützte Masse eingetaucht und

c) die Gegenstände werden nach dem Austauchen erforderlichenfalls einer Atmosphäre erhöhter Feuchtigkeit bzw. Wärme ausgesetzt.

2. Verfahren nach Anspruch 1, **dadurch gekennzeichnet,** dass als Gas getrocknete Luft verwendet wird.

3. Verfahren nach Anspruch 1, **dadurch gekennzeichnet,** dass als Gas Stickstoff verwendet wird.

4. Vorrichtung zur Durchführung des Verfahrens nach Anspruch 1, mit einer Tauchkammer (4), in der ein die flüssige Tauchmasse enthaltendes Gefäss (7) und Mittel (8, 9, 10, 11, 23) zum Durchmischen der Tauchmasse angeordnet sind, sowie mit einer Transporteinrichtung (14, 15, 17) mit einem Halter (12) zur Aufnahme mindestens eines der zu umhüllenden Gegenstände (13), um die Gegenstände (13) in die Tauchmasse ein- und anschliessend wieder auszutauchen, von wo sie einer Aushärtungsstation mit einer Atmosphäre erhöhter Feuchtigkeit zuführbar sind, **dadurch gekennzeichnet,** dass eine zur Eingabe bzw. zur Entnahme der Gegenstände (13) ausgebildete, räumlich mit der von der Aussenwelt abschliessbaren Tauchkammer (4) verbindbare Ladekammer (3) derart vorgesehen ist, dass die Gegenstände (13) mittels der Transporteinrichtung (14, 15, 17) von der Ladekammer (3) in die Tauchkammer (4) und nach dem Austauchen wieder in die Ladekammer (3) bewegbar sind, dass den beiden Kammern (3, 4) unabhängig voneinander ein Gas zur Erzeugung einer Atmosphäre mit bestimmter Feuchtigkeit zuführbar ist, wobei zum Einbringen des Gases in die Ladekammer (3) mindestens ein Zuführungselement (18) so angeordnet ist, dass das Gas vom Boden der Ladekammer (3) an den Gegenständen (13) vorbei nach oben strömt, und wobei zum Einbringen des Gases in die Tauchkammer (4) mindestens ein Zuführungselement (16) so angeordnet ist, dass das einströmende Gas unmittelbar auf die Oberfläche der flüssigen Masse gelangt und von dort ebenfalls nach oben strömt, und dass eine programmierbare Steuereinrichtung vorhanden ist, die die separate Gaszufuhr in die beiden Kammern (3, 4), eine Zugangstüre (26) zur Ladekammer (3), einen Schieber (5) zum räumlichen Verbinden bzw. Trennen der beiden Kammern (3,4), die Transporteinrichtung (14,15,17) sowie die Mittel (8, 9, 10, 11, 23) zum Durchmischen der Masse steuert.

5. Vorrichtung nach Anspruch 4, **dadurch gekennzeichnet,** dass die Steuereinrichtung bezüglich der Verschiebegeschwindigkeit der Transporteinrichtung (14, 15, 17), insbesondere der Ein- und Austauchgeschwindigkeit, bezüglich des Verschiebeweges, insbesondere der Eintauchtiefe, und bezüglich von Wartezeiten beim Ein- und nach dem Austauchen frei programmierbar ist.

6. Vorrichtung nach Anspruch 4, **dadurch gekennzeichnet,** dass zwischen einzelnen Tauchvorgängen oder nach erfolgtem Auswechseln des die Tauchmasse enthaltenden Gefässes (7) eine Durchmischung der neuen Tauchmasse während einer bestimmten Zeitspanne erfolgt, während der das Eintauchen von Gegenständen (13) verunmöglicht ist.

7. Vorrichtung nach Anspruch 6, **dadurch gekennzeichnet,** dass jeweils vor Beginn eines Tauchvorganges die Mittel (8, 9, 10, 11, 23) zum Durchmischen der Tauchmasse in eine das Eintauchen von Gegenständen (13) nicht behindernde Ausgangslage gebracht werden und bis zum Abschluss des Tauchvorganges dort verbleiben.

8. Vorrichtung nach einem der Ansprüche 4 bis 7, **dadurch gekennzeichnet,** dass in der Tauchkammer (4) ständig ein Gasüberdruck herrscht und von dort über die Ladekammer (3) Gas in die Aussenwelt entweichen kann.

9. Vorrichtung nach Anspruch 8, **dadurch gekennzeichnet,** dass der Schieber (5) während eines Tauchvorganges nur geöffnet wird, wenn die Feuchtigkeit in der Ladekammer (3) unter einem vorgegebenen Wert liegt.

10. Vorrichtung nach Anspruch 9, **dadurch gekennzeichnet,** dass die Ladekammer (3) über der Tauchkammer (4) angeordnet ist.

11. Vorrichtung nach einem der Ansprüche 4 bis 10, **dadurch gekennzeichnet,** dass als Aushärtungsstation ein geschlossenes, von aussen zugängliches Gehäuse (43) vorgesehen ist, dem ein Dampf- / Luftgemisch zur Erzeugung einer Atmosphäre bestimmter Feuchtigkeit derart zuführbar ist, dass die einströmende feuchte Luft die umhüllten Gegenstände (13) allseitig umströmt.

12. Vorrichtung nach Anspruch 11, **dadurch gekennzeichnet,** dass zum Aushärten der Umhüllung von in Reihen am Halter (12) hängenden Gegenständen (13) in einer quer zu den Reihen verlaufenden Ebene Zuführungselemente (33) mit Austrittsöffnungen für die feuchte Luft angeordnet sind, welche einerseits an eine Wasserdampf liefernde und andererseits an eine Druckluft liefernde Quelle derart anschliessbar sind, dass der Dampf unter Einfluss der Druckluft in das Gehäuse (43) ein- und die Gegenstände (13) allseitig umströmt.

13. Vorrichtung nach Anspruch 12, **dadurch gekennzeichnet,** dass parallel zu den Zuführungselementen (33) gegenüber von deren Austrittsöffnungen je ein Trennstab (55) angeordnet ist, der allenfalls austretendes Kondenswasser auffängt und in eine Sammelrinne (39) leitet.

14. Vorrichtung nach Anspruch 12 oder 13, **dadurch gekennzeichnet,** dass die Zuführungselemente (33) sowohl mit einem an eine Druckluftquelle anschliessbaren ersten Verteilrohr (35) als auch mit einem an eine Wasserdampfquelle anschliessbaren und sich im ersten Verteilrohr (35) befindlichen zweiten Verteilrohr (36) verbunden sind, wobei die Druckluft- und die Dampfzufuhr einstellbar sind.

15. Anwendung des Verfahrens nach Anspruch 1 zum umhüllen von elektrischen Schaltungen, insbesondere von auf einem Substrat aufgebrachten Hybridschaltungen mit einem Silikonkautschuk.

Fig. 3

Fig. 1

Fig. 2

Fig. 4

Fig. 5

Fig. 6

EP 0 334 022 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-2949388 (H.H. FLOURNOY JR. ET. AL.)<br>* Spalte 3, Zeile 5 - Zeile 59 *<br>--- | 1-2 | H05K13/00 |
| A | FR-A-2518808 (RTC LA RADIOTECHNIQUE-COMPELEC)<br>* Seite 5, Zeile 25 - Zeile 34 *<br>--- | 1 | |
| A,D | CH-A-662751 (SIEMENS)<br>* Seite 2, Zeile 1 - Zeile 19 *<br>----- | 1 | |

RECHERCHIERTE SACHGEBIETE (Int. Cl.4)

H05K
B05D
B01F

Der vorliegende Recherchenbericht wurde für alle Patentansprüche erstellt

| Recherchenort | Abschlußdatum der Recherche | Prüfer |
|---|---|---|
| DEN HAAG | 19 APRIL 1989 | TOUSSAINT F.M.A. |